# EUROPEAN PATENT APPLICATION

(11) **EP 3 920 301 A1**
(43) Date of publication of application: **08.12.2021**
(21) Application number: 20749231.5
(22) Date of filing: 30.01.2020
(51) Int. Cl.: H01M 10/0562, H01M 10/0585, H01M 10/36

(54) **SECONDARY BATTERY**

(30) Priority: 31.01.2019 JP 2019015088
(71) Applicant: Kabushiki Kaisha Nihon Micronics, Musashino-shi Tokyo 1808508 (JP)
(72) Inventor: TSUNOKUNI, Kazuyuki, Musashino-shi, Tokyo 180-8508 (JP); OGASAWARA, Juri, Musashino-shi, Tokyo 180-8508 (JP); TONOKAWA, Takashi, Musashino-shi, Tokyo 180-8508 (JP); KATO, Hiroyuki, Musashino-shi, Tokyo 180-8508 (JP)
(74) Representative: INNOV-GROUP
(86) International application number: PCT/JP2020/003429
(87) International publication number: WO 2020/158861

(57) **Abstract**

A technique of improving the performance of a secondary battery is provided. A secondary battery (100) according to an embodiment includes a first electrode (21), a second electrode (22), a first layer (11) disposed on the first electrode (21) and including a first n-type oxide semiconductor, a second layer (12) disposed on the first layer (11) and including a second n-type oxide semiconductor material and a first insulating material, a third layer (13) which is disposed on the second layer (12) and is a solid electrolyte layer, and a fourth layer (14) disposed on the third layer (13) and including hexagonal Ni(OH)₂ microcrystals.

## Description

### Technical Field

The present disclosure relates to a technique for improving the performance of a secondary battery.

### Background Art

Patent Literature 1 discloses a secondary battery including a first oxide semiconductor layer, a first charging layer, a second charging layer, a hydroxide layer, and a third oxide semiconductor layer between a first electrode and a second electrode. The third oxide semiconductor layer is nickel oxide (NiO), and the hydroxide layer is nickel hydroxide (Ni(OH)₂). The nickel hydroxide layer is formed by an electric stimulation step of performing electric processing after the second electrode is formed. That is, by applying a pulse voltage between the first electrode and the second electrode, the nickel hydroxide layer is formed between the second charging layer and the third oxide semiconductor layer.

Patent Literature 2 discloses a secondary battery including a first oxide semiconductor layer, a first charging layer, a second charging layer, and a third oxide semiconductor layer between a first electrode and a second electrode. The third oxide semiconductor layer is a p-type oxide semiconductor layer having a thickness between 200 nm and -1000 nm. Specifically, the third oxide semiconductor layer is a mixed layer of a p-type oxide semiconductor layer nickel oxide NiO and nickel hydroxide (Ni(OH)₂).

### Citation List

### Patent Literature

[Patent Literature 1] Japanese Unexamined Patent Application Publication No. 2018-37261
[Patent Literature 2] Japanese Unexamined Patent Application Publication No. 2018-152311

### Summary of Invention

### Technical Problem

In such a secondary battery, further improvement in the performance is desired.

An object of the present disclosure is to improve the performance of a secondary battery.

### Solution to Problem

An example aspect of an embodiment is a secondary battery including: a first electrode; a second electrode; a first layer disposed between the first electrode and the second electrode and including a first n-type oxide semiconductor material; a second layer disposed on the first layer and including a second n-type oxide semiconductor material and a first insulating material; a third layer which is disposed on the second layer and is a solid electrolyte layer; and a fourth layer disposed on the third layer and including hexagonal Ni(OH)₂ microcrystals.

In the above secondary battery, in an X-ray diffraction pattern obtained by performing X-ray diffraction measurement by a grazing incidence X-ray diffraction method on the fourth layer, there may be a first peak showing a diffraction intensity of a (001) plane of Ni(OH)₂ and a second peak showing a diffraction intensity of a (100) plane of Ni(OH)₂.

According to another example aspect of the embodiment, a secondary battery including: a first electrode; a second electrode; a first layer disposed between the first electrode and the second electrode and including a first n-type oxide semiconductor material; a second layer disposed on the first layer and including a second n-type oxide semiconductor material and a first insulating material; a third layer which is disposed on the second layer and is a solid electrolyte layer; and a fourth layer disposed on the third layer and including microcrystals of nickel hydroxide. In an X-ray diffraction pattern obtained by performing X-ray diffraction measurement by a grazing incidence X-ray diffraction method on the fourth layer, there are a first peak showing a diffraction intensity of a (001) plane of nickel hydroxide and a second peak showing a diffraction intensity of a (100) plane of Ni(OH)₂.

In the above secondary battery, a full width at half maximum of the first peak is preferably larger than a full width at half maximum of the second peak.

In the above secondary battery, a planar size of the microcrystal is preferably 200 nm or less.

In the above secondary battery, the fourth layer may be in contact with the second electrode.

In the above secondary battery, a thickness of the fourth layer may be 500 nm or more.

### Advantageous Effects of Invention

According to the present disclosure, it is possible to provide a technique of improving the performance of a secondary battery.

### Brief Description of Drawings

Fig. 1 schematically shows a laminated structure of a secondary battery according to the first embodiment;
Fig. 2 shows a surface SEM photograph of a fourth layer;
Fig. 3 shows a surface SEM photograph of the fourth layer;
Fig. 4 shows a surface SEM photograph of the fourth layer;
Fig. 5 shows a surface SEM photograph of the fourth layer;
Fig. 6 shows a cross-sectional SEM photograph of the fourth layer;
Fig. 7 shows an X-ray diffraction pattern of the fourth layer;
Fig. 8 schematically shows a crystal structure of Ni(OH)₂;
Fig. 9 is a flowchart showing a method of manufacturing the secondary battery; and
Fig. 10 shows a cross-sectional SEM photograph of the fourth layer.

### Description of Embodiments

An example of embodiments of the present disclosure will be described below with reference to the drawings. The following description shows preferred embodiments of the present disclosure, and the technical scope of the present disclosure is not limited to the following embodiments.

### [First embodiment]

### (Laminated structure of secondary battery)

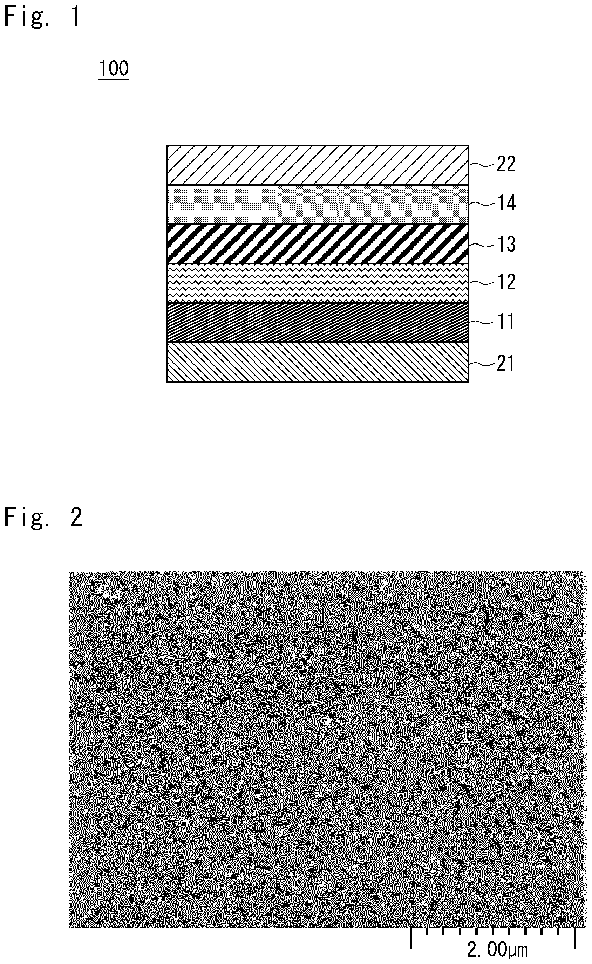

A basic configuration of a secondary battery according to this embodiment will be described below with reference to Fig. 1. Fig. 1 is a cross-sectional view schematically showing a laminated structure of the secondary battery 100.

In Fig. 1, the secondary battery 100 has a laminated structure in which a first electrode 21, a first layer 11, a second layer 12, a third layer 13, a fourth layer 14, and a second electrode 22 are laminated in this order.

### [First electrode 21]

The first electrode 21 becomes a negative electrode of the secondary battery 100. The first electrode 21 is a conductive sheet or a conductive substrate functioning as a base material. As the first electrode 21, for example, a metal foil sheet such as a SUS sheet or an aluminum sheet can be used. Note that it is also possible to prepare a base material formed of an insulator and form the first electrode 21 on the substrate. When the first electrode 21 is formed on an insulating base material, a metal material such as tungsten (W), chromium (Cr), or titanium (Ti) can be used as the material of the first electrode 21. As the material of the first electrode 21, an alloy film including aluminum (Al), silver (Ag) or the like may be used. When the first electrode 21 is formed on the base material, the first electrode 21 can be formed in the same manner as the second electrode 22 described later.

### [First layer 11]

The first layer 11 is disposed on the first electrode 21. The first layer 11 is disposed on the first electrode 21 on the side of the second electrode 22. The first layer 11 is formed in contact with the first electrode 21. The thickness of the first layer 11 is, for example, about 50 nm to 200 nm.

The first layer 11 includes an n-type oxide semiconductor material (a first n-type oxide semiconductor material). The first layer 11 is an n-type oxide semiconductor layer formed with a predetermined thickness. As the first layer 11, for example, titanium dioxide (TiO₂), tin oxide (SnO₂), or zinc oxide (ZnO) can be used. For example, the first layer 11 is an n-type oxide semiconductor layer formed on the first electrode 21 by sputtering, vapor deposition or the like. As the material of the first layer 11, it is particularly preferable to use titanium dioxide (TiO₂).

### [Second layer 12]

The second layer 12 functioning as a negative electrode active material is disposed on the first layer 11. The second layer 12 is disposed on the first layer 11 on the side of the second electrode 22. The second layer 12 is formed in contact with the first layer 11. The thickness of the second layer 12 is, for example, 200 nm to 3000 nm. The thickness of the second layer 12 may be, for example, 10 µm or more.

The second layer 12 includes an insulating material (a first insulating material). A silicone resin can be used as the first insulating material. For example, as the first insulating material, it is preferable to use a silicon compound (silicone) having a main skeleton bonded by siloxane such as a silicon oxide. Therefore, the second layer 12 includes silicon oxide (SiOₓ) as the first insulating material.

The second layer 12 includes an n-type oxide semiconductor material (a first insulating material) in addition to an insulating material (a second n-type oxide semiconductor material). That is, the second layer 12 is formed of a mixture of the first insulating material and the second n-type oxide semiconductor material. For example, a fine particles n-type oxide semiconductor can be used as the second n-type oxide semiconductor material.

For example, the second layer 12 is formed of silicon oxide and titanium oxide with the second n-type oxide semiconductor material used as titanium oxide. In addition, as the n-type oxide semiconductor material that can be used for the second layer 12, tin oxide (SnO₂), zinc oxide (ZnO), and magnesium oxide (MgO) are preferable. A combination of two, three, or all of titanium oxide, tin oxide, zinc oxide, and magnesium oxide may also be used.

The second n-type oxide semiconductor material included in the second layer 12 and the first n-type oxide semiconductor material included in the first layer 11 may be the same or different. For example, when the first n-type oxide semiconductor material included in the first layer 11 is titanium oxide, the second n-type oxide semiconductor material of the second layer 12 may be titanium oxide or an n-type oxide semiconductor material other than titanium oxide.

### [Third layer 13]

The third layer 13 functioning as a solid electrolyte is disposed on the second layer 12. The third layer 13 is disposed on the second layer 12 on the side of the second electrode 22. The third layer 13 is formed in contact with the second layer 12. The thickness of the third layer 13 is preferably 50 nm or more and 800 nm or less. The thickness of the third layer 13 may be 800 nm or more.

The third layer 13 adjusts the movement of H⁺ and electrons (e⁻). The third layer 13 is a layer including tantalum oxide. For example, the third layer 13 can be formed of a tantalum oxide film (TaOₓ film) having a predetermined thickness. Specifically, the third layer 13 is a TaOₓ layer formed on the second layer 12 by sputtering or the like. The third layer 13 is preferably an amorphous layer including tantalum oxide. Alternatively, the third layer 13 is preferably a nanoparticle layer including a plurality of tantalum oxide nanoparticles.

### [Fourth layer 14]

The fourth layer 14 functioning as a positive electrode active material layer or a solid electrolyte layer is disposed on the third layer 13. The fourth layer 14 is disposed on the third layer 13 on the side of the second electrode 22. The fourth layer 14 is formed in contact with the third layer 13. The fourth layer 14 includes nickel hydroxide (Ni(OH)₂). Specifically, a nickel hydroxide layer formed with a predetermined thickness becomes the fourth layer 14. The thickness of the fourth layer 14 is preferably 500 nm or more. The thickness of the fourth layer 14 is preferably 3600 nm or less.

The fourth layer 14 has a plurality of hexagonal microcrystals including Ni(OH)₂. The fourth layer 14 is an aggregate in which Ni(OH)₂ microcrystals are laminated. For example, a planar size of the microcrystals of Ni(OH)₂ is 200 nm or less. The fourth layer 14 may be formed by, for example, a pulling method or a convective self-assembly method. Further, a metallic material such as cobalt (Co) or zinc (Zn) for improving properties may be added to the nickel hydroxide layer of the fourth layer 14.

### [Second electrode 22]

The second electrode 22 is disposed on the fourth layer 14. The second electrode 22 is formed in contact with the fourth layer 14. The second electrode 22 may be formed of a conductive film. A metal material such as chromium (Cr) or copper (Cu) may be used as the material of the second electrode 22. An alloy film including aluminum (Al), silver (Ag) or the like may also be used as the material of the second electrode 22. Examples of the method of forming the alloy film include the vapor phase film deposition method such as sputtering, ion plating, electron beam vapor deposition, vacuum deposition, and chemical vapor deposition. The metal electrode can be formed by electrolytic plating, electroless plating or the like. As the metal used for plating, copper, a copper alloy, nickel, silver, gold, zinc, tin or the like can be commonly used. For example, the second electrode 22 is an Al film having a thickness of 300 nm.

The nickel hydroxide film is directly formed on the third layer 13 which is a solid electrolyte layer, thereby forming the fourth layer 14. By doing so, the fourth layer 14 can be formed as the nickel hydroxide layer having a sufficient thickness. Therefore, the storage capacity can be increased by increasing the positive electrode active material. Furthermore, by forming a structure in which microcrystals of Ni(OH)₂ are deposited, a metal material can be easily added.

On the other hand, in Patent Literature 1, the second electrode is formed by an electric stimulation step of performing electrical processing after the second electrode is formed. Therefore, the microcrystals of Ni(OH)₂ cannot be formed. Further, it is difficult to form a nickel hydroxide layer having a sufficient thickness.

In Patent Literature 2, a nickel oxide film containing hydrogen is formed by the sputter deposition method. Specifically, Ni or NiO is used as a target. The water is taken in from water vapor or moisture in the chamber of a sputter deposition apparatus. Therefore, the microcrystals of Ni(OH)₂ cannot be formed. Further, it is difficult to form a nickel hydroxide layer having a sufficient thickness.

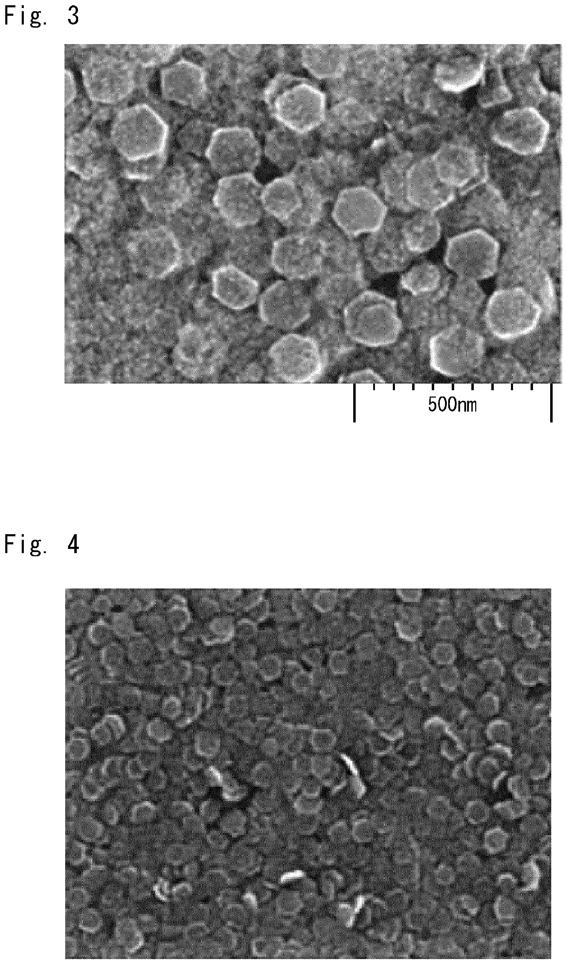

Figs. 2 and 3 show a surface SEM (Scanning Electron Microscope) photograph of the fourth layer 14. In Fig. 3, the magnification is larger than that of Fig. 2. As can be seen from Figs. 2 and 3, the planar size of the microcrystal is 200 nm or less. The planar size of the microcrystals can be measured from the surface SEM photograph.

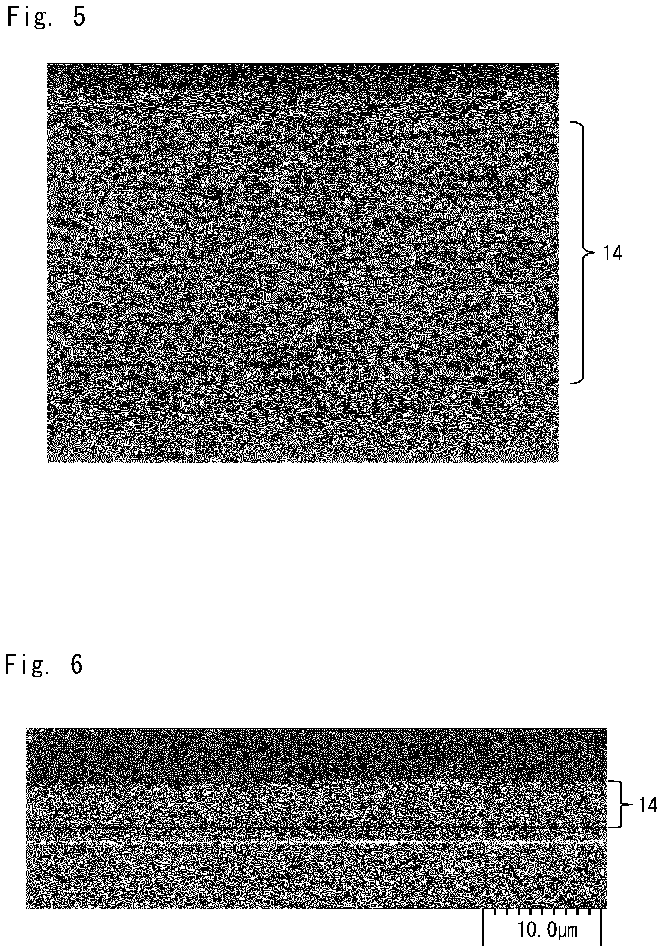

Fig. 4 is a surface SEM photograph of the fourth layer 14, and Fig. 5 is a cross-sectional SEM photograph. The fourth layer 14 is an aggregate of microcrystals having a planar size of about 100 nm and a thickness of about several tens of nm.

Fig. 6 shows an SEM photograph of a 3600 nm thick nickel hydroxide layer in a wider range, i.e., a cross-sectional SEM photograph at low magnification. As described above, even when the film thickness is 3600 nm, the nickel hydroxide layer having a microcrystal structure can be uniformly formed.

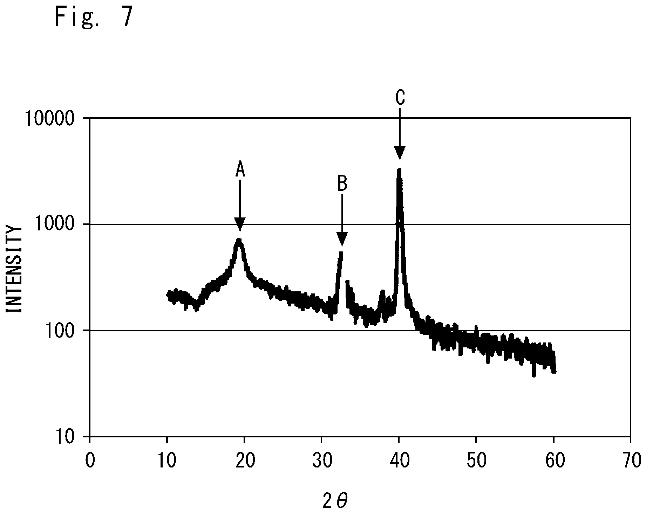

Fig. 7 shows an X-ray diffraction pattern (spectrum) with the fourth layer 14 exposed. In Fig. 7, the horizontal axis represents a diffraction angle 2θ (an angle between an incident X-ray direction and a diffracted x-ray direction), and the vertical axis represents a diffraction intensity (a.u). In this embodiment, X-ray diffraction measurement is performed by the grazing incidence X-ray diffraction method using CuKα rays each having a wavelength of 1.5418 angstroms.

Three peaks A to C appear in the X-ray diffraction pattern of the fourth layer 14. The peak A corresponds to a (001) plane of Ni(OH)₂. The peak B corresponds to a (100) plane of Ni(OH)₂. The peak C is caused by silicon (Si) included in the third layer 13 underlying the fourth layer 14. A peak of a diffraction angle of the (001) plane of Ni(OH)₂ is present in the X-ray diffraction pattern obtained by performing X-ray diffraction measurement by the grazing incidence X-ray diffraction method on the fourth layer 14. Further, in the X-ray diffraction pattern, there is a peak of the diffraction angle of the (100) plane of Ni(OH)₂. The peak of the (001) plane is larger than that of the (100) plane. A full width at half maximum of the peak of the (001) plane is larger than a full width at half maximum of the peak of the (100) plane.

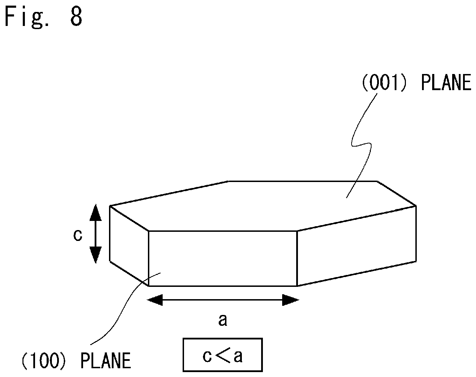

The crystal structure of Ni(OH)₂ will be described with reference to Fig. 8. Ni(OH)₂ has a hexagonal crystal structure as shown in Fig. 8. The hexagonal crystal plane is referred to as the (001) plane, and a square crystal plane is referred to as the (100) plane. Ni(OH)₂ has a hexagonal crystal structure, and the lattice constant of the c-axis is about 4.6 angstroms. The X-ray diffraction peak corresponding to the (001) plane is 2θ = 19.581°. The X-ray diffraction peak corresponding to the (100) plane is 2θ = 33.40°. From the X-ray diffraction pattern and the surface SEM photograph, it is inferred that the crystal is a thin hexagonal planar microcrystal in the c-axis direction.

The battery performance can be improved by depositing Ni(OH)₂ having such a crystal structure as the fourth layer 14. That is, by forming the fourth layer 14 having the above crystal structure on the third layer 13 serving as the solid electrolyte layer, the battery performance can be improved. For example, the storage capacity can be increased by increasing the positive electrode active material layer. In addition, since the fourth layer 14 can be formed without using the electric stimulation step, failures caused by the electric stimulation can be reduced.

### (Manufacturing process)

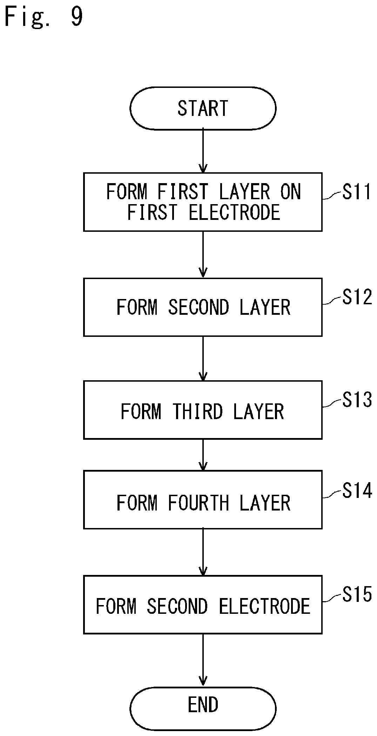

Next, a method of manufacturing the secondary battery 100 according to this embodiment will be described with reference to Fig. 9. Fig. 9 is a flowchart showing a method of manufacturing the secondary battery 100.

First, the first layer 11 is formed on the first electrode 21 (S11). The first layer 11 includes the first n-type oxide semiconductor material as described above. For example, in the first layer 11, a TiO₂ film can be formed as the first layer 11 by sputtering using Ti or TiO as a target. The first layer 11 can be a TiO₂ film having a thickness of 50 nm to 200 nm. The first electrode 21 is, for example, a tungsten electrode.

Next, the second layer 12 is formed on the first layer 11 (S12). The second layer 12 can be formed by the coating pyrolysis method. First, a coating liquid is prepared by mixing a solvent with a mixture of a precursor of titanium oxide, tin oxide, or zinc oxide and silicone oil. An example in which the second layer 12 is formed of silicon oxide as the first insulating material and titanium oxide as the second n-type oxide insulating material will be described. In this case, the fatty acid titanium can be used as the precursor of the titanium oxide. Fatty acid titanium and silicone oil are stirred together with a solvent to prepare the coating liquid.

The coating liquid is applied onto the first layer 11 by the spin coating method, the slit coating method or the like. Specifically, the coating liquid is applied by a spin coating apparatus at a rotational speed of 500 to 3000 rpm.

Then, the coating film is dried, baked, and irradiated with UV light, so that the second layer 12 can be formed on the first layer 11. For example, the workpiece is dried on a hot plate after the coating liquid is applied. The drying temperature on the hot plate is about 30 °C to 200 °C, and the drying time is about 5 minutes to 30 minutes. After the workpiece is dried, the workpiece is baked in the atmosphere using a baking furnace. The baking temperature is, for example, about 300 °C to 600 °C, and the baking time is about 10 minutes to 60 minutes.

Thus, the aliphatic acid salt is decomposed to form a fine particle layer of titanium dioxide covered with the insulating film of silicone. Specifically, the fine particle layer has a structure in which a metal salt of titanium dioxide coated with silicone is buried in the silicone layer. The coating film after baking is irradiated with UV light by a low-pressure mercury lamp. UV exposure time is 10 to 60 min.

When the second n-type oxide semiconductor is titanium oxide, for example, titanium stearate can be used as another example of the precursor. Titanium oxide, tin oxide, and zinc oxide are formed by decomposing an aliphatic acid salt which is a precursor of a metal oxide. For titanium oxide, tin oxide, zinc oxide, and the like, it is also possible to use fine particles of an oxide semiconductor without using a precursor. Nanoparticles of titanium oxide or zinc oxide are mixed with silicone oil to produce a mixture. Further, a solvent is mixed with the mixture to produce the coating liquid.

The third layer 13 is formed on the second layer 12 (S13). The third layer 13 includes the tantalum oxide as described above. For example, the third layer 13 can be formed by sputtering using Ta or Ta₂O₅ as a target. Alternatively, instead of the sputter deposition, the film formation method such as the vapor deposition or ion plating can be used. The TaOₓ film can be formed as the third layer 13 by using these film forming methods. In the sputter deposition, only an argon (Ar) gas may be used, or an oxygen (O₂) gas may be added to the argon gas and then supplied. The third layer 13 may be a TaOₓ film having a thickness of 50 nm or more and 800 nm or less. Here, as the third layer 13, it is preferable to form an amorphous TaOₓ film or a TaOₓ film in which a plurality of tantalum oxide nanoparticles are deposited.

The fourth layer 14 is formed on the third layer 13 (S14). The fourth layer 14 is formed using, for example, the pulling method or the convective self-assembly method. Nickel nitrate and ammonia are neutralized to produce microcrystals of nickel hydroxide. The generated microcrystals are deposited and laminated on the third layer 13 by the pulling method or the convective self-assembly method. In this way, the nickel hydroxide film can be formed. Therefore, the microcrystalline layer of nickel hydroxide can be formed as the fourth layer 14. It is possible to form a 3500 nm thick nickel hydroxide layer by the convective self-assembly method.

Next, the second electrode 22 is formed on the fourth layer 14 (S15). Examples of the method of forming the second electrode 22 include the vapor phase film deposition method such as sputtering, ion plating, electron beam vapor deposition, vacuum deposition, and chemical vapor deposition. Note that the second electrode 22 may be partially formed using a mask. The second electrode 22 can be formed by the electrolytic plating method, the electroless plating method or the like. As the metal used for the plating, copper, a copper alloy, nickel, silver, gold, zinc, tin or the like can commonly be used. For example, the second electrode 22 is an Al film having a thickness of 300 nm.

By the above manufacturing method, the high-performance secondary battery 100 can be manufactured with high productivity. For example, the storage capacity can be increased by increasing the positive electrode active material. Further, in the step of forming the fourth layer 14, the formation of microcrystals and the film formation step can be separated from each other. That is, after the formation of microcrystals, the nickel hydroxide film having hexagonal microcrystals can be deposited on the third layer 13. Further, a metal material (Co, Zn, etc.) for improving properties can be easily added during the microcrystal formation processing. Furthermore, the electric stimulation step can be omitted.

### [Second embodiment]

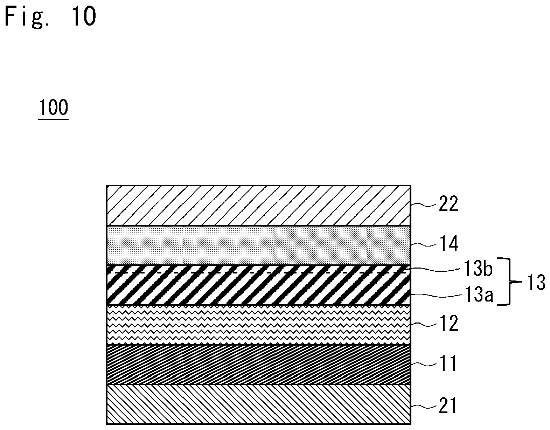

A configuration of a secondary battery 100A according to a second embodiment will be described with reference to Fig. 10. Fig. 10 is a cross-sectional view showing the configuration of the secondary battery 100A. In the secondary battery 100A, a third layer 13 functioning as an electrolyte layer has a two-layer structure. Specifically, the third layer 13 includes a TaOₓ layer 13a and a TEOS layer 13b. The configuration other than the third layer 13 is the same as that of the first embodiment, and thus a description of the secondary battery 100A according to the second emobdiment is omitted.

The TEOS layer 13b is disposed on the TaOₓ layer 13a. That is, the TEOS layer 13b is formed between the TaOₓ layer 13a and the second electrode 22. The TEOS layer 13b is in contact with the TaOₓ layer 13a and the second electrode 22. Since the TaOₓ layer 13a is similar to the TaOₓ layer which is the third layer 13 according to the first embodiment, a description of the TaOₓ layer 13a will be omitted.

The TEOS layer 13b is formed by chemical vapor deposition method (CVD method) using Tetra ethyl ortho silicate (TEOS). The film thickness of the TEOS layer 13b can be, for example, about 50 nm to 200 nm.

In such a configuration, the same effect as that of the first embodiment can be obtained. That is, since a nickel hydroxide layer containing hexagonal microcrystals is formed as the fourth layer 14, the storage capacity can be increased.

The secondary battery may have a layer other than the first layer 11 to the fourth layer 14 between the electrodes. That is, layers other than the first layer 11 to the fourth layer 14 described above may be added. The third layer 13 serving as the electrolyte layer may be formed of a material other than those according to the first and second embodiments.

While examples of embodiments of the present disclosure have been described above, the present disclosure includes appropriate modifications that do not impair objects and advantages of the present disclosure, and is not limited by the embodiments described above.

This application claims priority on the basis of Japanese Patent Application No. 2019-15088, filed January 31, 2019, the entire disclosure of which is incorporated herein by reference.

### Reference Signs List

- 100: SECONDARY BATTERY
- 11: FIRST LAYER
- 12: SECOND LAYER
- 13: THIRD LAYER
- 14: FOURTH LAYER
- 21: FIRST ELECTRODE
- 22: SECOND ELECTRODE

## Claims

1. A secondary battery comprising:
a first electrode;
a second electrode;
a first layer disposed between the first electrode and the second electrode and including a first n-type oxide semiconductor material;
a second layer disposed on the first layer and including a second n-type oxide semiconductor material and a first insulating material;
a third layer which is disposed on the second layer and is a solid electrolyte layer; and
a fourth layer disposed on the third layer and including hexagonal Ni(OH)₂ microcrystals.

2. The secondary battery according to Claim 1, wherein
in an X-ray diffraction pattern obtained by performing X-ray diffraction measurement by a grazing incidence X-ray diffraction method on the fourth layer, there are a first peak showing a diffraction intensity of a (001) plane of Ni(OH)₂ and a second peak showing a diffraction intensity of a (100) plane of Ni(OH)₂.

3. A secondary battery comprising:
a first electrode;
a second electrode;
a first layer disposed between the first electrode and the second electrode and including a first n-type oxide semiconductor material;
a second layer disposed on the first layer and including a second n-type oxide semiconductor material and a first insulating material;
a third layer which is disposed on the second layer and is a solid electrolyte layer; and
a fourth layer disposed on the third layer and including microcrystals of nickel hydroxide, wherein
in an X-ray diffraction pattern obtained by performing X-ray diffraction measurement by a grazing incidence X-ray diffraction method on the fourth layer, there are a first peak showing a diffraction intensity of a (001) plane of Ni(OH)₂ and a second peak showing a diffraction intensity of a (100) plane of Ni(OH)₂.

4. The secondary battery according to Claim 2 or 3, wherein
a full width at half maximum of the first peak is larger than a full width at half maximum of the second peak.

5. The secondary battery according to any one of Claims 1 to 4, wherein
a planar size of the microcrystal is 200 nm or less.

6. The secondary battery according to any one of Claims 1 to 5, wherein
the fourth layer is in contact with the second electrode.

7. The secondary battery according to any one of Claims 1 to 6, wherein
a thickness of the fourth layer is 500 nm or more.
